# DEMANDE DE BREVET EUROPEEN

(11) **EP 3 300 113 A1**
(43) Date de publication de la demande: **28.03.2018**
(21) Numéro de dépôt: 17156164.0
(22) Date de dépôt: 15.02.2017
(51) Int. Cl.: H01L 27/12, H01L 27/092, H01L 21/28, H01L 29/423, H01L 29/66

(54) **CIRCUIT INTEGRE A TRANSISTORS MOS ET SON PROCEDE DE FABRICATION**

(30) Priorité: 27.09.2016 FR 1659090
(71) Demandeur: STMicroelectronics (Crolles 2) SAS, 38920 Crolles (FR)
(72) Inventeur: RIBES, Guillaume C, 38190 Bernin (FR); DUMONT, Benjamin, 38410 Saint Martin d'Uriage (FR); ARNAUD, Franck, 38330 Saint Nazaire les Eymes (FR)
(74) Mandataire: Thibon, Laurent

(57) **Abrégé**

L'invention concerne un circuit intégré à transistors MOS de type FDSOI comprenant au moins un transistor MOS logique d'un premier type (NMOS_{L}), au moins un transistor MOS logique d'un deuxième type (PMOS_{L}) et au moins un transistor MOS analogique du premier type (NMOS_{A}), formés dans et sur une couche semiconductrice (1) reposant sur une couche isolante (3), dans lequel l'empilement de grille (9) des transistors logiques (NMOS_{L}, PMOS_{L}) comporte successivement une couche d'isolant de grille (11, 13), une première couche de nitrure de titane (15), une couche de lanthane (17) et une deuxième couche de nitrure de titane (19) ; et l'empilement de grille (23) du transistor analogique (NMOS_{A}) comprend les mêmes couches (11, 13, 17, 19) que l'empilement de grille (9) des transistors logiques (NMOS_{L}, PMOS_{L}) à l'exception de la première couche de nitrure de titane (15). L'invention concerne également un procédé de fabrication d'un tel circuit.

## Description

### Domaine

La présente demande concerne un circuit intégré à transistors MOS et son procédé de fabrication. On s'intéresse plus particulièrement au cas où les transistors MOS sont de type FDSOI ("Fully Depleted Semiconductor On Insulator" - semiconducteur sur isolant complétement déplété). De tels transistors sont formés dans une couche semiconductrice reposant sur un isolant et ayant une épaisseur inférieure à 20 nm, voire à 10 nm.

### Exposé de l'art antérieur

Dans un circuit intégré, on appelle transistors MOS logiques les transistors utilisés pour implémenter des fonctions logiques, et transistors MOS analogiques les transistors utilisés pour implémenter des fonctions analogiques.

Les transistors logiques sont destinés à traiter des signaux numériques, ou signaux logiques, ayant un niveau haut et un niveau bas correspondant aux deux valeurs binaires '1' et '0'. De tels transistors logiques sont réalisés de sorte qu'ils commutent rapidement et consomment peu d'énergie électrique. Les tensions de seuil des transistors MOS logiques à canal N, NMOS_{L}, et celles des transistors MOS logiques à canal P, PMOS_{L}, sont généralement optimisées en prévoyant des empilements de grille pour les transistors NMOS_{L} différents de ceux pour les transistors PMOS_{L}. Cela implique de recourir à de nombreuses étapes de masquage, de dépôt et de gravure de couches pour former ces empilements de grille différents.

Les transistors analogiques sont destinés à traiter, par exemple à amplifier, des signaux analogiques. Il est souhaitable que ces signaux analogiques ne soient pas déformés par les transistors analogiques, et donc que les tensions de seuil des transistors analogiques soient aussi faibles que possibles. Du fait que les performances des transistors MOS à canal N sont meilleures que celles des transistors MOS à canal P, les fonctions analogiques d'un circuit intégré sont le plus souvent implémentées uniquement avec des transistors MOS analogiques à canal N, NMOS_{A}. Ces transistors analogiques NMOS_{A} sont généralement réalisés de la même façon que les transistors logiques NMOS_{L} ce qui pose divers problèmes, notamment pour abaisser les tensions de seuil des transistors NMOS_{A} jusqu'à des valeurs aussi faibles que possible.

### Résumé

Un mode de réalisation prévoit un circuit intégré à transistors MOS et son procédé de fabrication qui pallient au moins certains des inconvénients des circuits intégrés existants.

Un mode de réalisation prévoit un circuit intégré à transistors MOS de type FDSOI comprenant au moins un transistor MOS logique d'un premier type, au moins un transistor MOS logique d'un deuxième type et au moins un transistor MOS analogique du premier type, formés dans et sur une couche semiconductrice reposant sur une couche isolante, dans lequel : l'empilement de grille des transistors logiques comporte successivement une couche d'isolant de grille, une première couche de nitrure de titane, une couche de lanthane et une deuxième couche de nitrure de titane ; et l'empilement de grille du transistor analogique comprend les mêmes couches que l'empilement de grille des transistors logiques à l'exception de la première couche de nitrure de titane.

Selon un mode de réalisation, la couche d'isolant de grille comprend une couche à forte permittivité en un matériau isolant dont la permittivité est supérieure à 15.

Selon un mode de réalisation, ledit matériau isolant est choisi dans le groupe comprenant l'oxyde d'hafnium, l'oxynitrure d'hafnium, et l'oxyde de zirconium.

Selon un mode de réalisation, l'épaisseur de la couche semiconductrice est comprise entre 5 et 20 nm, de préférence entre 6 et 13 nm.

Selon un mode de réalisation, la longueur de grille des transistors est inférieure à 30 nm.

Selon un mode de réalisation, l'épaisseur de la couche de lanthane est comprise entre 0,2 et 1 nm, de préférence entre 0,35 et 0,45 nm.

Selon un mode de réalisation, l'épaisseur de la première couche de nitrure de titane est comprise entre 1 et 5 nm, de préférence entre 2 et 3 nm.

Un autre mode de réalisation prévoit un procédé de fabrication d'un circuit intégré comprenant des transistors MOS logiques d'un premier type et d'un deuxième type à empilement de grille identique, et au moins un transistor MOS analogique du premier type, le procédé comprenant, pour la formation des empilements de grille des transistors, des étapes successives suivantes : a) prévoir une couche semiconductrice reposant sur une couche isolante ; b) former une couche d'isolant de grille ; c) former une première couche de nitrure de titane ; d) retirer par gravure la première couche de nitrure de titane à l'emplacement du transistor MOS analogique ; e) former une couche de lanthane ; et f) former une deuxième couche de nitrure de titane.

Selon un mode de réalisation, l'étape b) comprend la formation d'une couche d'interface isolante sur la couche semiconductrice suivie de la formation d'une couche à forte permittivité en un matériau dont la permittivité est supérieure à 15.

Selon un mode de réalisation, l'épaisseur de la couche d'interface est inférieure à 2 nm, l'épaisseur de la couche à forte permittivité est inférieure à 2 nm, l'épaisseur de la première couche de nitrure de titane est comprise entre 1 et 5 nm, de préférence entre 2 et 3 nm, l'épaisseur de la couche de lanthane est comprise entre 0,2 et 1 nm, de préférence entre 0,35 et 0,45 nm, et l'épaisseur de la deuxième couche de nitrure de titane est comprise entre 1 et 5 nm, de préférence entre 3,5 et 4,5 nm.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 illustre un mode de réalisation d'un circuit intégré à transistors MOS ; et
les figures 2A à 2D illustrent des étapes successives d'un mode de réalisation d'un procédé de fabrication d'un circuit intégré du type de celui de la figure 1.

### Description détaillée

De mêmes éléments ont été désignés par les mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés.

Dans la description qui suit, les termes "arrière", "gauche", "droite", "supérieur", "inférieur", etc., se réfèrent à l'orientation des éléments concernés dans les figures correspondantes. Sauf précision contraire, l'expression "de l'ordre de" signifie à 10 % près, de préférence à 5 % près.

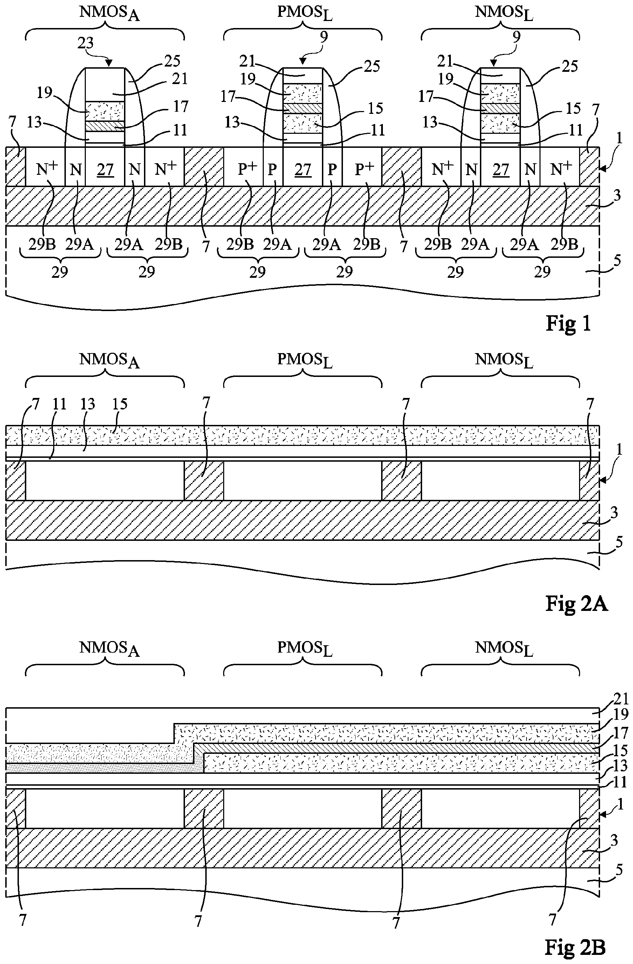

La figure 1 est une vue en coupe illustrant schématiquement un mode de réalisation d'un circuit intégré à transistors MOS de type FDSOI. Ce circuit intégré comprend au moins un transistor MOS logique à canal N, NMOS_{L}, au moins un transistor MOS logique à canal P, PMOS_{L}, et au moins un transistor analogique à canal N, NMOS_{A}. Un seul exemplaire de chacun de ces transistors NMOS_{L}, PMOS_{L} et NMOS_{A} est représenté, respectivement à droite, au centre et à gauche en figure 1.

Les transistors NMOS_{L}, PMOS_{L} et NMOS_{A} sont formés dans et sur une couche semiconductrice 1 reposant sur un isolant 3, lui-même reposant sur un substrat 5. Des murs isolants 7 s'étendant à travers toute l'épaisseur de la couche semiconductrice 1 délimitent chaque transistor NMOS_{L}, PMOS_{L}, NMOS_{A} et les isolent électriquement d'autres composants formés dans la couche semiconductrice 1.

Les transistors logiques NMOS_{L} et PMOS_{L} ont des empilements de grille 9 identiques. Chaque empilement de grille 9 comprend, sur la couche semiconductrice 1, un isolant de grille comportant une couche isolante d'interface 11 revêtue d'une couche isolante 13 en un matériau à forte permittivité diélectrique. L'isolant de grille 11, 13 est revêtu d'une électrode conductrice de grille comportant successivement, à partir de la couche 13, une couche 15 de nitrure de titane, une couche 17 en lanthane, une couche 19 en nitrure de titane, et une couche supérieure 21, par exemple en silicium polycristallin dopé. Les couches 11, 13, 15, 17, 19 et 21 reposent les unes sur les autres et sont en contact deux à deux.

Le transistor analogique NMOS_{A} a un empilement de grille 23 comportant les mêmes couches que les empilements de grille 9 des transistors logiques, à l'exception de la couche de nitrure de titane inférieure 15. Ainsi, dans le transistor analogique NMOS_{A}, la couche de lanthane 17 repose directement sur la couche isolante 13, contrairement au cas des transistors logiques NMOS_{L} et PMOS_{L} où la couche de lanthane 17 est séparée de la couche isolante 13 par la couche de nitrure de titane 15.

Dans ce mode de réalisation, chaque empilement de grille 9, 23 est bordé d'espaceurs 25 et repose sur une portion 27 non dopée de la couche semiconductrice 1. La portion 27 s'étend entre des régions correspondantes de source et de drain 29 formées dans la couche semiconductrice 1 et dopées de type N dans les transistors NMOS_{A} et NMOS_{L} ou de type P dans les transistors PMOS_{L}. Plus particulièrement, chaque région 29 comporte une portion 29A disposée sous un espaceur 25 correspondant, et une portion 29B plus fortement dopée que la portion 29A et disposée au-delà de l'empilement de grille et des espaceurs. Les portions 29A sont couramment appelées extensions de drain ou LDD de l'anglais Lightly Doped Drain (drain peu dopé).

Selon un avantage, la présence de la couche de lanthane 17 directement sur l'isolant de grille 11, 13 des transistors analogiques NMOS_{A} contribue à abaisser les tensions de seuil de ces transistors jusqu'à des valeurs très faibles, par exemple inférieures à 100 mV.

Selon un autre avantage, bien que les empilements de grille des transistors PMOS_{L} et NMOS_{L} soient identiques, les couches choisies ici pour constituer ces empilements de grille 9 permettent d'obtenir des tensions de seuil optimisées tant pour les transistors NMOS_{L} que pour les transistors PMOS_{L}, par exemple des tensions de seuil inférieures à 500 mV. Cet avantage résulte notamment de la présence de la couche inférieure de nitrure de titane 15 intercalée entre la couche de lanthane 17 et la couche isolante 13, l'épaisseur de cette couche 15 étant déterminée à l'aide de logiciels de simulation tels que les logiciels commercialisés sous les appellations ELDO® ou SPECTRE®.

Selon un autre avantage, les empilements de grille 9 des transistors PMOS_{L} ne comprennent pas de couche d'aluminium généralement utilisée pour optimiser les tensions de seuil de ces transistors PMOS_{L}. Il en résulte une diminution du nombre d'étapes nécessaires à la fabrication de ces empilements de grille par rapport au cas d'empilements de grille comprenant une telle couche d'aluminium.

Par ailleurs, les tensions de seuil des transistors NMOS_{L}, PMOS_{L}, et NMOS_{A} peuvent être optimisées indépendamment les unes des autres, par exemple pour que les tensions de seuil des transistors NMOS_{L} soient égales à celles des transistors PMOS_{L}. Pour cela, les dimensions et/ou les niveaux de dopage des portions 29A et/ou 29B des régions de source/drain 29 d'un type de transistors donné, à savoir NMOS_{L} ou PMOS_{L} ou NMOS_{A}, peuvent être adaptés. On peut également prévoir d'appliquer des tensions de polarisation sur des électrodes de grille arrière (non représentées) disposées sous la couche isolante 3, en regard des empilements de grille des transistors. Dans ce dernier cas, on tire profit du fait que ces transistors sont réalisés dans et sur une couche semiconductrice de type SOI ("Semiconductor On Insulator" - semiconducteur sur isolant).

A titre d'exemple de matériaux, la couche semiconductrice 1 peut être une couche de silicium, de germanium, ou de silicium-germanium. La couche isolante 3 peut être en oxyde de silicium. Le substrat 5 peut être en silicium. La couche isolante d'interface 11 peut être une couche d'oxyde de silicium ou d'oxynitrure de silicium. La couche isolante 13 est en un matériau dit "high-k" dont la permittivité diélectrique est supérieure à 15, par exemple de l'oxyde d'hafnium, de l'oxynitrure d'hafnium, ou de l'oxyde de zirconium.

A titre d'exemple de dimensions, dans le cas où la longueur de grille des transistors, prise entre les régions de drain et de source 29, est inférieure à 30 nm, par exemple égale à 28 nm, les diverses couches peuvent avoir les dimensions suivantes :
- une épaisseur inférieure à 20 nm, de préférence comprise entre 6 et 13 nm, par exemple 6 nm pour la couche semiconductrice 1,
- une épaisseur inférieure à 2 nm, par exemple 1,5 nm, pour la couche d'interface 11,
- une épaisseur inférieure à 2 nm, par exemple 1,8 nm, pour la couche à forte permittivité 13,
- une épaisseur comprise entre 1 et 5 nm, de préférence entre 2 et 3 nm, par exemple 2,5 nm, pour la couche inférieure de nitrure de titane 15,
- une épaisseur comprise entre 0,2 et 1 nm, de préférence entre 0,35 et 0,45 nm, par exemple 0,4 nm, pour la couche de lanthane 17, et
- une épaisseur comprise entre 1 et 5 nm, de préférence entre 3,5 et 4,5 nm, par exemple 4 nm, pour la couche supérieure de nitrure de titane 19.

On considère un circuit intégré du type de celui de la figure 1 dans lequel les dimensions et les matériaux des diverses couches des transistors sont celles et ceux indiqués ci-dessus à titre d'exemple. Pour une tension d'alimentation de l'ordre de 1 V, des essais ont montré que les tensions de seuil des transistors analogiques NMOS_{A}, en régime linéaire, sont alors seulement de l'ordre de 55 mV. En outre, ces essais ont montré que les tensions de seuil des transistors logiques PMOS_{L} et NMOS_{L}, en régime saturé, sont de l'ordre de -200 mV et de 300 mV respectivement. Ainsi, les tensions de seuil des transistors logiques NMOS_{L} sont avantageusement égales, en valeur absolue et à plus ou moins 150 mV, à celles des transistors PMOS_{L}. En outre, ces tensions de seuil sont avantageusement au moins deux fois plus faibles que la tension d'alimentation du circuit intégré.

Pour fabriquer un circuit intégré comprenant des transistors NMOS_{L}, PMOS_{L} et NMOS_{A} tels que décrits en relation avec la figure 1, un procédé classique comprendrait des étapes successives de dépôt uniforme d'une couche de lanthane 17 sur l'isolant de grille 11, 13 de ces transistors, puis de retrait par gravure de cette couche de lanthane 17 uniquement à l'emplacement des transistors logiques NMOS_{L} et PMOS_{L}. Toutefois, il s'avère que les procédés de gravure du lanthane sont particulièrement agressifs et la gravure du lanthane 17 à l'emplacement des transistors logiques PMOS_{L} et NMOS_{L} entrainerait une gravure au moins partielle de l'isolant de grille 11, 13 de ces transistors. Ces derniers auraient donc des caractéristiques de grille dégradées.

Les figures 2A à 2D sont des vues en coupe illustrant une structure à des étapes successives d'un procédé de fabrication évitant les inconvénients du procédé classique brièvement décrit ci-dessus. Dans ces figures, un seul transistor NMOS_{A}, un seul transistor PMOS_{L} et un seul transistor NMOS_{L} ont été représentés.

A l'étape de la figure 2A, une couche isolante d'interface 11, une couche isolante à forte permittivité 13 et une couche inférieure de nitrure de titane 15 ont été successivement formées à l'emplacement des transistors NMOS_{A}, PMOS_{L} et NMOS_{L}, par exemple sur toute la surface de la couche semiconductrice 1 comme cela est représenté ici.

On notera que la première étape ci-dessus est une étape de dépôt, sur l'isolant de grille 11, 13, d'une couche de nitrure de titane 15 et non de lanthane. De manière avantageuse, des procédés de gravure sélective du nitrure de titane sont disponibles. On évite donc, comme on le verra ci-après, de graver du lanthane reposant directement sur l'isolant de grille 11, 13 au niveau des zones de formation des empilements de grille 9 des transistors logiques PMOS_{L} et NMOS_{L}.

A l'étape de la figure 2B, la couche inférieure de nitrure de titane 15 a été retirée par gravure à l'emplacement du transistor analogique NMOS_{A} et laissée en place à l'emplacement des transistors logiques PMOS_{L} et NMOS_{L}. Une couche de lanthane 17, une couche supérieure de nitrure de titane 19 et une couche de silicium polycristallin dopé 21 ont ensuite été successivement formées avant de procéder à un polissage aplanissant de la face supérieure de la couche 21.

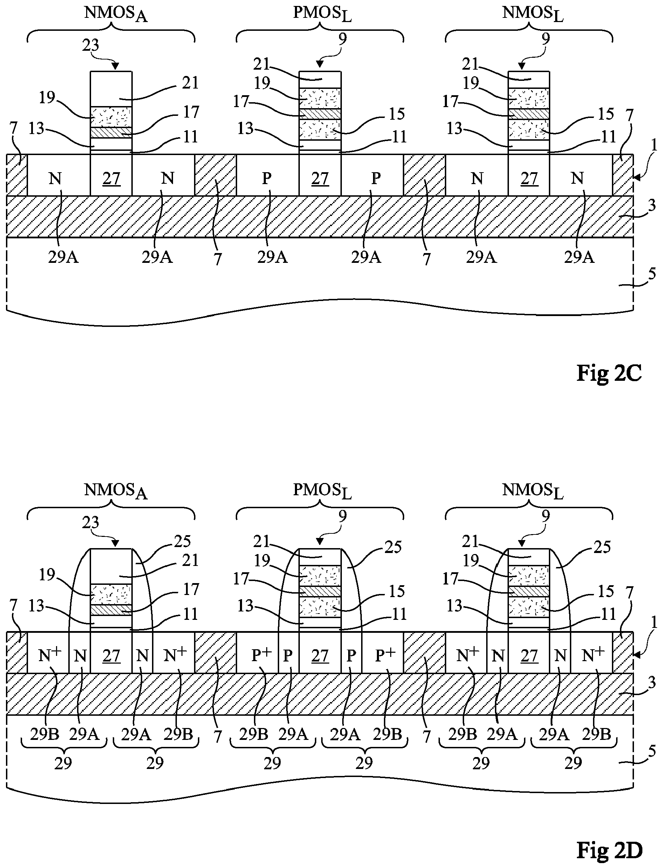

A l'étape de la figure 2C, les empilements de grille 9 et 23 des transistors NMOS_{A}, PMOS_{L} et NMOS_{L} ont été formés en gravant, jusqu'à la couche semiconductrice 1, les couches 11, 13, 15, 17, 19 et 21 de manière à laisser en place des portions de ces couches correspondant aux empilements de grille. Les régions de source et de drain 29, et plus particulièrement les portions LDD 29A, ont ensuite été formées par implantation d'atomes dopants, de part et d'autre des empilements de grille 9, 23.

De manière avantageuse, lors de la gravure de la couche de lanthane 17 pour définir les empilements de grille 9 et 23 dans les couches 11, 13, 15, 17, 19 et 21, même si les couches 11, 13 et 15 sur lesquelles repose le lanthane 17 sont partiellement gravées, cela ne pose pas de problème puisque ces couches 11, 13 et 15 doivent de toute manière être retirées. De préférence, une fois le retrait du lanthane 17 par gravure terminé, la couche de nitrure de titane 15 est retirée par gravure sélective par rapport à l'isolant de grille 11, 13, puis l'isolant de grille 11, 13 est retiré par gravure sélective par rapport à la couche semiconductrice 1 ce qui permet avantageusement de ne pas modifier la surface supérieure de cette couche 1 lors de la formation des empilements de grille 9 et 23.

A l'étape de la figure 2D, des espaceurs 25 ont été formés sur les flancs des empilements de grilles 9, 23, puis de nouvelles étapes d'implantation d'atomes dopants ont été effectuées pour former les portions 29B fortement dopées des régions de source et de drain 29, les portions 29A subsistant sous les espaceurs 25.

Dans le procédé décrit ci-dessus, les empilements de grille 9, 23 des transistors NMOS_{A}, NMOS_{L}, PMOS_{L} sont formés lors des mêmes étapes à l'exception de l'étape de gravure de la couche de nitrure inférieure 15 spécifique au transistor NMOS_{A}. Il en résulte que ce procédé est plus simple, plus rapide et moins coûteux à mettre en oeuvre que les procédés existants de fabrication d'un circuit intégré comportant des transistors MOS logiques à canal N et P et des transistors MOS analogiques à canal N.

Des modes de réalisation particuliers ont été décrits. Diverses variantes et modifications apparaîtront à l'homme de l'art. En particulier, la couche conductrice 21 peut être réalisée à l'aide d'une ou plusieurs couches conductrices, par exemple des couches en des matériaux conducteurs autres que du silicium polycristallin dopé. Dans le cas où la couche conductrice 21 est partiellement ou totalement réalisée en silicium polycristallin dopé, on peut prévoir que le type de conductivité du silicium polycristallin dans les transistors à canal N soit différent de celui dans les transistors à canal P.

La portion 27 de la couche semiconductrice peut être plus faiblement dopée de type N ou P que les régions 29A. Par exemple, on peut prévoir qu'à l'étape de la figure 2A la couche semiconductrice soit faiblement dopée de type N ou P.

Les espaceurs bordant les empilements de grille 9 peuvent être différents de ceux bordant les empilements de grille 23, notamment en ce qui concerne leurs dimensions, leurs nombres et les matériaux qui les composent. Plusieurs espaceurs peuvent être prévus de part et d'autre des empilements de grille 9, 23, le nombre de ces espaceurs pouvant être différent pour les transistors analogiques et les transistors logiques.

Bien que cela ne soit pas décrit, dans le procédé de fabrication illustré par les figures 2A à 2D, après l'étape de la figure 2D, des étapes de siliciuration et/ou de formation d'une structure d'interconnexion sont couramment prévues pour connecter les empilements de grille 9, 23 et les régions de source/drain 29 des transistors. Des étapes d'épitaxie des régions de source/drain 29 peuvent également être mises en oeuvre.

## Revendications

1. Circuit intégré à transistors MOS de type FDSOI comprenant au moins un transistor MOS logique d'un premier type (NMOS_{L}), au moins un transistor MOS logique d'un deuxième type (PMOS_{L}) et au moins un transistor MOS analogique du premier type (NMOS_{A}), formés dans et sur une couche semiconductrice (1) reposant sur une couche isolante (3), dans lequel :
l'empilement de grille (9) des transistors logiques (NMOS_{L}, PMOS_{L}) comporte successivement une couche d'isolant de grille (11, 13), une première couche de nitrure de titane (15), une couche de lanthane (17) et une deuxième couche de nitrure de titane (19) ; et
l'empilement de grille (23) du transistor analogique (NMOS_{A}) comprend les mêmes couches (11, 13, 17, 19) que l'empilement de grille (9) des transistors logiques (NMOS_{L}, PMOS_{L}) à l'exception de la première couche de nitrure de titane (15).

2. Circuit intégré selon la revendication 1, dans lequel la couche d'isolant de grille (11, 13) comprend une couche à forte permittivité (13) en un matériau isolant dont la permittivité est supérieure à 15.

3. Circuit intégré selon la revendication 2, dans lequel ledit matériau isolant est choisi dans le groupe comprenant l'oxyde d'hafnium, l'oxynitrure d'hafnium, et l'oxyde de zirconium.

4. Circuit intégré selon l'une quelconque des revendications 1 à 3, dans lequel l'épaisseur de la couche semiconductrice (1) est comprise entre 5 et 20 nm, de préférence entre 6 et 13 nm.

5. Circuit intégré selon l'une quelconque des revendications 1 à 4, dans lequel la longueur de grille des transistors (NMOS_{L}, PMOS_{L}, NMOS_{A}) est inférieure à 30 nm.

6. Circuit intégré selon l'une quelconque des revendications 1 à 5, dans lequel l'épaisseur de la couche de lanthane (17) est comprise entre 0,2 et 1 nm, de préférence entre 0,35 et 0,45 nm.

7. Circuit intégré selon l'une quelconque des revendications 1 à 6, dans lequel l'épaisseur de la première couche de nitrure de titane (15) est comprise entre 1 et 5 nm, de préférence entre 2 et 3 nm.

8. Procédé de fabrication d'un circuit intégré comprenant des transistors MOS logiques d'un premier type et d'un deuxième type (NMOS_{L}, PMOS_{L}) à empilement de grille identique (9), et au moins un transistor MOS analogique du premier type (NMOS_{A}), le procédé comprenant, pour la formation des empilements de grille des transistors, des étapes successives suivante :
a) prévoir une couche semiconductrice (1) reposant sur une couche isolante (3) ;
b) former une couche d'isolant de grille (11, 13) ;
c) former une première couche de nitrure de titane (15) ;
d) retirer par gravure la première couche de nitrure de titane (15) à l'emplacement du transistor MOS analogique (NMOS_{A});
e) former une couche de lanthane (17) ; et
f) former une deuxième couche (19) de nitrure de titane.

9. Procédé de fabrication selon la revendication 8, dans lequel l'étape b) comprend la formation d'une couche d'interface isolante (11) sur la couche semiconductrice (1) suivie de la formation d'une couche à forte permittivité (13) en un matériau dont la permittivité est supérieure à 15.

10. Procédé de fabrication selon la revendication 9, dans lequel l'épaisseur de la couche d'interface (11) est inférieure à 2 nm, l'épaisseur de la couche à forte permittivité (13) est inférieure à 2 nm, l'épaisseur de la première couche de nitrure de titane (15) est comprise entre 1 et 5 nm, de préférence entre 2 et 3 nm, l'épaisseur de la couche de lanthane (17) est comprise entre 0,2 et 1 nm, de préférence entre 0,35 et 0,45 nm, et l'épaisseur de la deuxième couche de nitrure de titane (19) est comprise entre 1 et 5 nm, de préférence entre 3,5 et 4,5 nm.
